# EUROPÄISCHE PATENTSCHRIFT

(11) **EP 0 862 665 B1**
(45) Veröffentlichungstag und Bekanntmachung des Hinweises auf die Patenterteilung: **15.03.2000**
(21) Anmeldenummer: 96939882.5
(22) Anmeldetag: 21.11.1996
(51) Int. Cl.: C25D 5/18, C25D 3/38

(54) **VERFAHREN ZUR ELEKTROLYTISCHEN ABSCHEIDUNG VON METALLSCHICHTEN**
PROCESS FOR THE ELECTROLYTIC DEPOSITION OF METAL LAYERS
PROCEDE DE DEPOT DE COUCHES METALLIQUES PAR VOIE ELECTROLYTIQUE

(30) Priorität: 21.11.1995 DE 19545231
(43) Veröffentlichungstag der Anmeldung: 09.09.1998
(73) Patentinhaber: ATOTECH Deutschland GmbH, 10553 Berlin (DE)
(72) Erfinder: DAHMS, Wolfgang, D-13437 Berlin (DE); MEYER, Heinrich, D-14109 Berlin (DE); KRETSCHMER, Stefan, D-12353 Berlin (DE)
(74) Vertreter: Effert, Bressel und Kollegen
(86) Internationale Anmeldenummer: EP9605140
(87) Internationale Veröffentlichungsnummer: WO9719206

(56) Entgegenhaltungen:
- EP-A- 0 402 896
- GB-A- 1 396 436

## Beschreibung

Die Erfindung betrifft ein Verfahren zur elektrolytischen Abscheidung von Metallschichten mit gleichmäßiger Schichtdicke, insbesondere von Kupferschichten, bestimmter physikalisch-mechanischer und optischer Eigenschaften.

Um bestimmte physikalisch-mechanische Eigenschaften von Metallschichten, die elektrolytisch abgeschieden werden, zu erreichen, müssen der Abscheidelösung bestimmte Additivverbindungen in geringen Mengen zugegeben werden. Hierbei handelt es sich vorwiegend um organische Stoffe, die sich auf die Glanzbildung, Einebnung, Gleichmäßigkeit der Abscheidung auf großen Flächen, Vermeidung der sogenannten Anbrennungen, d.h. Abscheidung grobkristalliner Schichten, sowie die Bildung von Metallschichten mit hoher Bruchelongation und Zugfestigkeit auswirken.

Nachteilig ist hierbei, daß diese Stoffe bei der Abscheidung in der Regel zersetzt werden, so daß sie während des Betriebes ergänzt werden müssen. Allerdings ist die Einhaltung konstanter Bedingungen unter Produktionsbedingungen meist sehr schwierig, da die Stoffe selbst nur in sehr geringen Konzentrationen in den Abscheidelösungen enthalten sind, ferner meist auch eine komplizierte Mischung mehrerer derartiger Stoffe zum Erreichen bestimmter Schichteigenschaften benötigt werden und schließlich sich bei der Zersetzung auch Abbauprodukte bilden, die sich ebenfalls auf die Metallschichteigenschaften auswirken. Daher ist eine analytische Erfassung der Additivverbindungen nicht nur sehr schwierig, sondern reicht in der Regel auch nicht zur vollständigen Beschreibung des Zustandes des Abscheidebades aus, so daß analytische Verfahren zur Kontrolle des Bades nur bedingt brauchbar sind.

Ferner wird gefordert, bei der Beschichtung von komplex geformten Werkstücken, beispielsweise von Leiterplatten mit sehr feinen Bohrungen, eine möglichst gleichmäßige Metallschichtdicke an allen Stellen des Werkstückes zu erreichen. Mit geeigneten Abscheidebädern mit optimierter Zusammensetzung ist es möglich, auch an Orten mit geringerer Stromdichte die Metallschichtdicke zu vergrößern. Jedoch beeinflussen die genannten Additivverbindungen die Metallstreuung nur unwesentlich, so daß das Problem durch diese Optimierungsmaßnahmen noch nicht gelöst wurde.

Insbesondere war es mit den genannten Maßnahmen nicht möglich, auch eine ausreichend gleichmäßige Verteilung der Metallschichtdicke an komplex geformten Werkstücken zu erreichen, beispielsweise an Leiterplatten mit sehr feinen Bohrungen.

Daher sind in der Literatur verschiedene Lösungsmöglichkeiten vorgeschlagen worden, die jedoch sämtlich noch nicht zu insgesamt befriedigenden Lösungen geführt haben.

Als eine Lösung zur Vergleichmäßigung der Metallverteilung auf den Oberflächen des zu beschichtenden Werkstückes wird vorgeschlagen, bei der Metallabscheidung unlösliche Anoden zu verwenden. Derartige Anoden sind beispielsweise aus der deutschen Patentschrift DD 215 589 B5 und der Druckschrift DD 261 613 A1 bekannt. Ferner sind derartige Verfahren auch in DE 43 44 387 A1 beschrieben. In diesen Druckschriften ist auch die Zugabe von Verbindungen von elektrochemisch reversiblen Redoxsystemen zur Abscheidelösung angegeben, mit denen die Zugabe von Metallsalzen zur Ergänzung der abgeschiedenen Metallionen vermieden werden soll.

Als eine weitere Lösung zur Vergleichmäßigung der Schichtdicke auf den Werkstücken wurde eine periodische Stromumkehr beim Elektrolysieren vorgeschlagen ("Pulse Plating - Elektrolytische Metallabscheidung mit Pulsstrom", Hrsg. Jean-Claude Puippe und Frank Leaman, Eugen G. Leuze Verlag, Saulgau, Deutschland, 1986, Seite 26 und "Pulse Plating of Copper for Printed Circuit Technology", M.R. Kalantary, D.R. Gabe, Metal Finishing, 1991, Seiten 21 bis 27). Jedoch kann damit eine ausreichende Gleichmäßigkeit der abgeschiedenen Metallschichten auf großen und zudem komplex geformten Werkstücken nicht erreicht werden.

Ferner wird in DE 27 39 427 C2 ein Verfahren zur gleichmäßigen Beschichtung von profilierten Werkstücken beschrieben, welche enge Vertiefungen aufweisen. Hierzu werden die Vertiefungen in der Oberfläche des Werkstückes sehr intensiv mit Elektrolytlösung angeströmt und gleichzeitig eine elektrische Folge von Impulsen von 1 µsec bis 50 µsec Dauer mit dazwischen liegenden wesentlich größeren Pausen zur elektrolytischen Behandlung an das Werkstück angelegt. Dieses Verfahren ist jedoch sehr aufwendig, da eine gezielte Anströmung von Profilierungen in Werkstückoberflächen zumindest für die Massenproduktion nicht möglich ist oder einen sehr hohen apparativen Anpassungsaufwand erfordert.

In WO-89/07162 A1 ist ein elektrochemisches Verfahren zur Abscheidung von Metallen beschrieben, vorzugsweise von Kupfer aus einem schwefelsauren Kupferelektrolyten mit organischen Additivverbindungen zur Verbesserung der physikalisch-mechanischen Eigenschaften, auf Werkstücken, beispielsweise Leiterplatten. Hierzu wird Wechselstrom mit unterschiedlich langen kathodischen und anodischen Pulsen angewendet. Es wird erreicht, daß die Schichten auf komplex geformten Werkstücken, wie beispielsweise Leiterplatten, mit gleichmäßigerer Schichtdicke abgeschieden werden. Weitere Hinweise darauf, wie das Problem bewältigt werden kann, unterschiedliche Schichtdicken durch Veränderung der geometrischen Verhältnisse in der elektrolytischen Zelle, beispielsweise durch Auflösung der Anoden, zu vermeiden, werden nicht gegeben.

Bei der Wiederholung der dort beschriebenen Versuche, konnte eine verbesserte Metallstreuung in feinen Bohrlöchern von Leiterplatten nach eigenen Erkenntnissen nur dann erreicht werden, wenn das optische Aussehen der nach der in der Druckschrift beschriebenen Methode abgeschiedenen Kupferschicht gleichzeitig schlechter wurde. Ferner war die Duktilität dieser Schichten so gering, daß sie bereits bei einem einmaligen, 10 Sekunden andauernden Eintauchen einer beschichteten Leiterplatte mit Bohrungen in ein 288 °C heißes Lotbad Risse in der Kupferschicht, vorzugsweise am Übergang von der Leiterplattenoberfläche zur Bohrlochwand erkennbar waren.

In dem Aufsatz "Hartverchromung mittels eines Gleichrichters mit pulsierenden Wellen und periodischer Umkehr der Polarität" von C. Co-lombini in der Fachzeitschrift Galvanotechnik, 1988, Seiten 2869 bis 2871 ist ebenfalls ein Verfahren beschrieben, bei dem die Metallschichten nicht mit Gleichstrom, sondern mit pulsierendem Wechselstrom abgeschieden werden. Dies dient nach dem Vorschlag des Autors dazu, Chromschichten herzustellen, die korrosionsbeständiger sind als herkömmliche Schichten. Allerdings ist in dieser Druckschrift angegeben, daß die nach dieser Methode gebildeten Chromschichten grau und nicht glänzend sind, so daß sie zur Erzeugung einer glänzenden Oberfläche nachpoliert werden müssen. Davon abgesehen, daß eine derartige mechanische Nachbehandlung außerordentlich aufwendig und damit teuer ist, kann diese in vielen Fällen gar nicht durchgeführt werden, beispielsweise dann wenn die zu bearbeitenden Oberflächenstellen nicht zugänglich sind.

In dem Aufsatz "Pulse Reverse Copper Plating For Printed Circuit Boards" von W.F. Hall et al., Proc. of the American Electrochemical Society, 10th Plating in the Electronic Industry Symposium, San Francisco, Ca., Febr. 1983 ist ferner angegeben, daß mittels einer Pulsstrommethode abgeschiedene Kupferschichten aus Abscheidelösungen mit glanzbildenden Stoffen auf Leiterplatten in gleichmäßigerer Schichtdicke gebildet werden können als mit Gleichstrom abgeschiedene Kupferschichten.

Die Kupferschichten sind matt, nach Angaben in der Druckschrift teilweise sogar braun oder orange, und bestehen folglich nicht aus reinem Kupfer. Insofern ist es verwunderlich, daß nach Angaben der Autoren hohe Duktilitätswerte, namentlich hohe Bruchelongations- und Zugfestigkeitswerte mit der angegebenen Methode erreichbar seien. Es werden jedoch keine hinreichend präzisen Angaben über die Abscheidungsbedingungen, wie beispielsweise Badzusammensetzung, Temperatur des Bades, verwendete Anoden usw. gegeben.

In EP 0 356 516 A1 ist eine Einrichtung zum Auftragen von galvanischen Überzügen offenbart, mit der nach Ansicht der Erfinder die physikalisch-mechanischen Eigenschaften der Überzüge verbessert werden können. Hierzu werden während der Abscheidung die Amplitude, Form und Frequenz der durch das elektrolytische Bad fließenden Ströme automatisch verändert. Es wird auch angegeben, daß durch eine Messung und Stabilisierung des Stromes des galvanischen Bades während des Auftragens galvanischer Überzüge ebenfalls die physikalisch-mechanischen Eigenschaften verbessert werden.

In EP 0 129 338 B1 ist ein Verfahren zur elektrolytischen Behandlung der Oberfläche einer Metallbahn unter Verwendung von Graphitelektroden beschrieben, bei dem durch Anwendung von Wechselstrom mit asymmetrischen positiven und negativen Halbwellen während der elektrolytischen Behandlung die Auflösung der als Anoden verwendeten Graphitelektroden vermieden werden kann, so daß sich die Stromverteilung in der Graphitelektrode nicht mehr verändert und damit konstante Verhältnisse
beim Elektrolysieren erhalten werden. Allerdings werden in dieser Druckschrift keine Hinweise gegeben, wie eine Verbesserung der physikalisch-mechanischen Eigenschaften abgeschiedener Metallschichten und gleichzeitig auch über eine lange Betriebsdauer eine möglichst gleichmäßige Schichtdickenverteilung erreicht werden können.

Aus EP-A-0 402 896 ist eine saure, kupferhaltige Lösung für ein elektrolytisches Abscheidungsverfahren bekannt, die zur Beschichtung von gedruckten Leiterplatten mit Löchern geeignet ist. Die Lösung enthält ferner ein organisches Additiv, das zur Kornverfeinerung und Aufhellung dient. Zur Stabilisierung des Additivs ist ein Übergangsmetall enthalten, das in zwei positiven Oxidationsstufen auftreten kann. Unter anderem ist Fe genannt. Als Anode ist ein Titankorb mit darin befindlichen Kupferteilen offenbart.

Aus GB-A-1 396 436 ist ein Verfahren zur elektrolytischen Herstellung von hartmagnetischen Schichten auf nichtrigiden Substraten bekannt.

Zur wirtschaftlichen und einfachen Herstellung von Leiterplatten ist es erforderlich, Kupferschichten mit sehr guten mechanisch-physikalischen Eigenschaften abzuscheiden, insbesondere mit einer hohen Bruchelongation und gleichmäßigem Glanz auch im hohen Stromdichtebereich. Da zunehmend feinste Bohrungen in den Leiterplatten enthalten sind und wegen der zunehmenden Integration der Bauelemente auf den Leiterplatten auch erhöhte Anforderungen an die Gleichmäßigkeit der Schichtdicke an der Oberfläche der Leiterplatten gestellt werden, müssen elektrolytische Abscheideverfahren für Kupfer gefunden werden, mit denen die genannten Anforderungen erreicht werden. Mit den bekannten Verfahren ist jedoch insbesondere nach langer Betriebszeit mit einem Abscheidebad ohne aufwendige Reinigungsprozeduren oder sogar einem Neuansatz eine Abscheidung qualitativ hochwertiger und gleichmäßig dicker Metallschichten auch auf großflächigen Substraten, die zudem komplex geformt sein können, nicht mehr sicher möglich. Insbesondere ist es mit den bekannten Verfahren nicht möglich, die genannten Anforderungen auch bei Anwendung hoher Stromdichten zu erzielen. Da üblicherweise in diesem Fall grobkristalline Metallniederschläge erhalten werden (Anbrennungen), sind die physikalisch-mechanischen wie auch die optischen Eigenschaften derart hergestellter Überzüge unbefriedigend, so daß auch von daher Bedarf für eine Verbesserung der bekannten Verfahren besteht.

Der vorliegenden Erfindung liegt von daher das Problem zugrunde, die Nachteile der Verfahren nach dem Stand der Technik zu vermeiden und insbesondere ein wirtschaftliches und einfaches Verfahren zur elektrolytischen Abscheidung von Metallschichten, insbesondere aus Kupfer, zu finden, wobei die nach dem Verfahren abgeschiedenen Metallschichten sehr gute physikalisch-mechanische und optische Eigenschaften aufweisen, beispielsweise Glanz auch an Stellen auf den Werkstückoberflächen, an denen das Metall mit hoher Stromdichte abgeschieden wird, und hohe Bruchelongation auch nach längerer Betriebsdauer eines Abscheidebades und die Metallschichtdicken an allen Stellen auf der Oberfläche des Behandlungsgutes, einschließlich vorhandener feiner Bohrungen, nahezu gleich ist. Ferner sollen die physikalisch-mechanischen Eigenschaften der Überzüge auch bei Anwendung hoher Stromdichten, beispielsweise von mindestens 6 A/dm² zu beschichtender Oberfläche, höchsten Anforderungen gerecht werden (unter anderem hinsichtlich Bruchelongation und Zugfestigkeit).

Das Problem wird gelöst durch das Verfahren gemäß Patentanspruch 1. Bevorzugte Ausführungsformen der Erfindung sind in den Unteransprüchen 2 bis 9 angegeben.

Es hat sich gezeigt, daß eine verbesserte Schichtdickenverteilung abgeschiedener Metallschichten, insbesondere von Kupferschichten, auf der Oberfläche komplex geformter Werkstücke und in Bohrungen in den Werkstücken mittels eines Pulsstrom- oder Pulsspannungsverfahrens ermöglicht wird, ohne daß dadurch die physikalisch-mechanischen Eigenschaften der abgeschiedenen Metallschichten, insbesondere gleichmäßiger Glanz und hohe Bruchelongation, beeinträchtigt werden. Wenn als Anoden dimensionsstabile, unlösliche Anoden verwendet werden, kann zudem die Metallverteilung auf den Werkstückaußenseiten wesentlich gleichmäßiger erhalten werden. Enthält die Abscheidelösung neben den Ionen des abgeschiedenen Metalls und den Additivverbindungen zur Steuerung der physikalisch-mechanischen Eigenschaften schließlich auch Verbindungen eines elektrochemisch reversiblen Redoxsystems, durch dessen oxidierte Form im übrigen die Ionen des abgeschiedenen Metalls durch Auflösung entsprechender Metallteile gebildet werden, so können auch optisch und in den physikalisch-mechanischen Eigenschaften einwandfreie Schichten bei Anwendung hoher Stromdichten (beispielsweise über 6 A/dm²) erreicht werden.

Insbesondere können gleichmäßig hochglänzende Kupferschichten auf Leiterplatten mit feinen Bohrungen abgeschieden werden, die auch eine mehrmalige Thermoschockbehandlung in einem Lotbad (jeweils 10 Sekunden Eintauchen in ein 288 °C heißes Bad und anschließendes Abkühlen auf Raumtemperatur) überstehen, ohne daß sich Risse in der Kupferschicht bilden. Die erreichbare Metallschichtverteilung in den Bohrungen und auf der Oberfläche der Leiterplatten ist dabei sehr gut. Dadurch ist es möglich, geringere Mengen Metall auf den Leiterplatten abzuscheiden als nach bekannten Verfahren, da die erforderlichen Schichtdicken in den Bohrungen schneller erreicht werden.

Bei den bekannten Verfahren unter Verwendung unlöslicher Anoden und Anwendung von Gleichstrom wird beobachtet, daß die physikalisch-mechanischen Eigenschaften der abgeschiedenen Metallschichten sowie die Metallschichtverteilung auf dem Werkstück dann schlechter werden, wenn das Abscheidebad über eine längere Zeit hinweg betrieben und damit gealtert wird. Dieser nachteilige Effekt wird beim Einsatz des beanspruchten Verfahrens ebenfalls nicht festgestellt.

Durch die erfindungsgemäßen Maßnahmen wird erreicht, daß organische Additivverbindungen in den Abscheidelösungen zur Erzeugung von Metallschichten mit vorgegebenen Eigenschaften eingesetzt werden können, ohne daß sich diese in nennenswertem Maße zersetzen. Spezielle Additivgemische sind nicht erforderlich. Ferner wird eine hohe kathodische Stromdichte erreicht. Dadurch wird ein wirtschaftliches Verfahren ermöglicht, da die zu behandelnden Werkstücke nur relativ kurz in der Anlage verweilen müssen, um mit einer Metallschicht mit vorgegebener Dikke beschichtet zu werden. Es wird eine lange Lebensdauer der dimensionsstabilen, unlöslichen Anoden erreicht, da nur äußerst geringe Mengen aggressiver Reaktionsprodukte an den Anoden entstehen.

Beim Pulsstromverfahren wird der Strom zwischen den als Kathode polarisierten Werkstücken und den Anoden galvanostatisch eingestellt und mittels geeigneter Mittel zeitlich moduliert. Beim Pulsspannungsverfahren wird eine Spannung zwischen den Werkstücken und den Anoden potentiostatisch eingestellt und die Spannung zeitlich moduliert, so daß sich ein zeitlich veränderlicher Strom einstellt.

Durch das Pulsstrom- oder Pulsspannungsverfahren werden variierende Spannungen an das Werkstück angelegt oder variierende Ströme zwischen dem Werkstück und der dimensionsstabilen, unlöslichen Gegenelektrode eingestellt. Beispielsweise wird eine Pulsstromfolge mit anodischen und kathodischen Strompulsen an den Werkstücken und gegebenenfalls mit dazwischen liegenden Ruhepausen mit der Stromstärke Null periodisch wiederholt. Bei entsprechender Einstellung einer Spannungspulsfolge stellt sich dann die genannte Strompulsfolge ein.

In einer bevorzugten Ausführungsform wird der Strom der anodischen Strompulse auf mindestens denselben Wert eingestellt wie der Strom der kathodischen Strompulse an den Werkstücken, vorzugsweise auf einen Wert, der zwei- bis dreimal so hoch ist, wie der Wert der kathodischen Strompulse.

Die Dauer eines anodischen Strompulses an den Werkstücken wird beispielsweise zwischen 0,1 Millisekunden (msec) und 1 Sekunde (sec) eingestellt. Vorzugsweise betragen die anodischen Pulslängen von 0,3 bis 10 Millisekunden. Insgesamt muß die Ladungsmenge zur Abscheidung des Metalls größer sein als die, die zur anodischen Rücklösung des Metalls vom Werkstück führt.

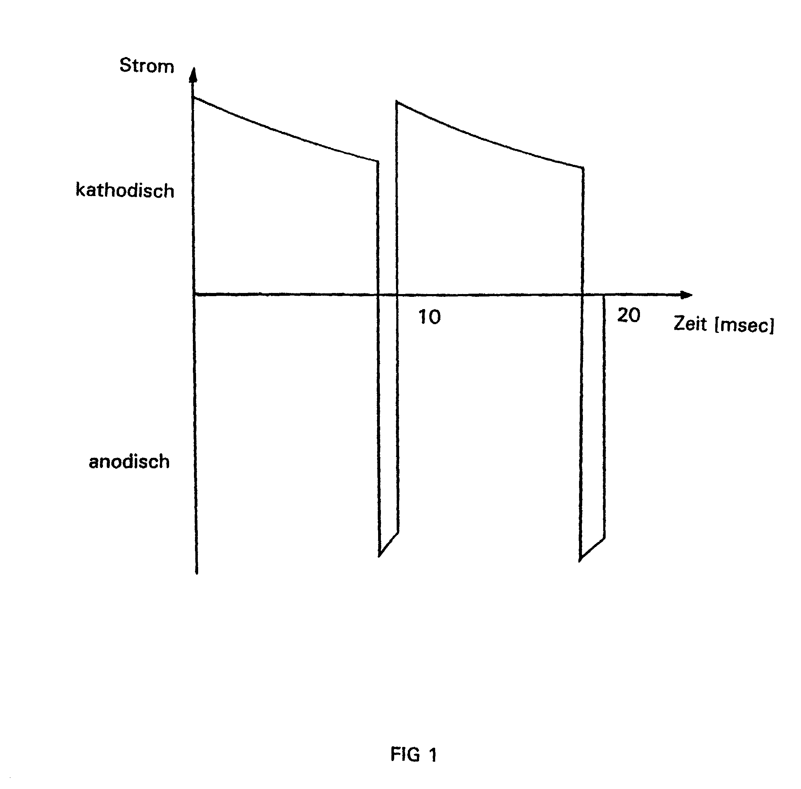

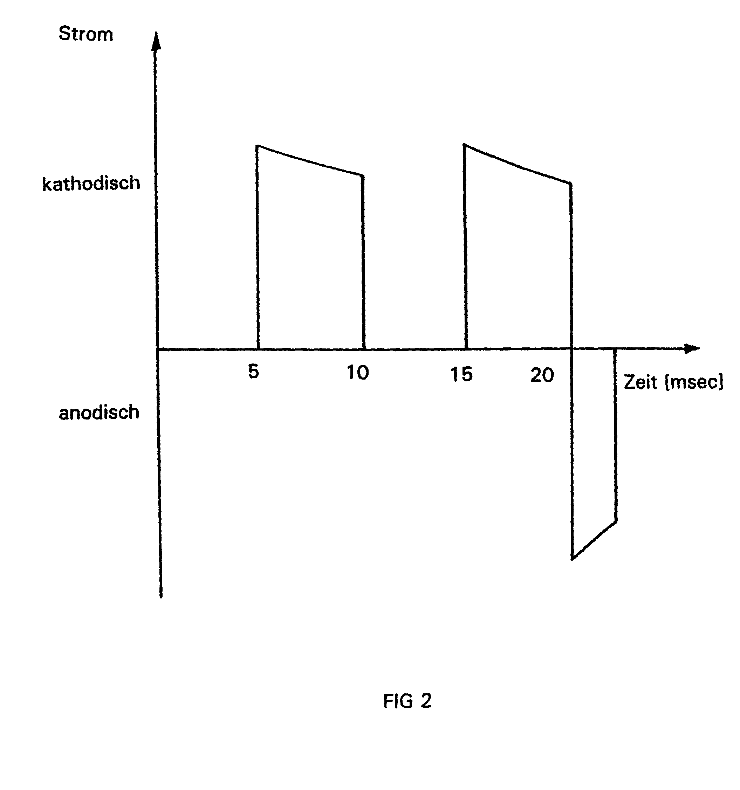

Typische Pulsfolgen sind in den Figuren 1 und 2 dargestellt. In Figur 1 wird zunächst ein kathodischer Strompuls mit einer Dauer von 9,5 Millisekunden am Werkstück eingestellt. Unmittelbar daran schließt sich ein anodischer Strompuls, der einen etwa doppelt bis dreifach so hohen Spitzenwert aufweist. Dieser Doppelpuls wird mit einer Frequenz von 100 Hertz periodisch wiederholt.

In Figur 2 ist eine Pulsfolge angegeben, die zu verbesserten Ergebnissen führt. Die erste kathodische Phase schließt sich an eine 5 Millisekunden lange Ruhephase an, bei der der Strom Null ist. Der anschließende kathodische Strompuls dauert 5 Millisekunden lang. Danach folgt wieder eine 5 Millisekunden lange Ruhepause und anschließend wiederum ein 5 Millisekunden andauernder kathodischer Strompuls. Erst danach schließt sich ein 1 Millisekunden langer anodischer Strompuls an. Dessen Höhe ist nur wenig höher als die der kathodischen Strompulse.

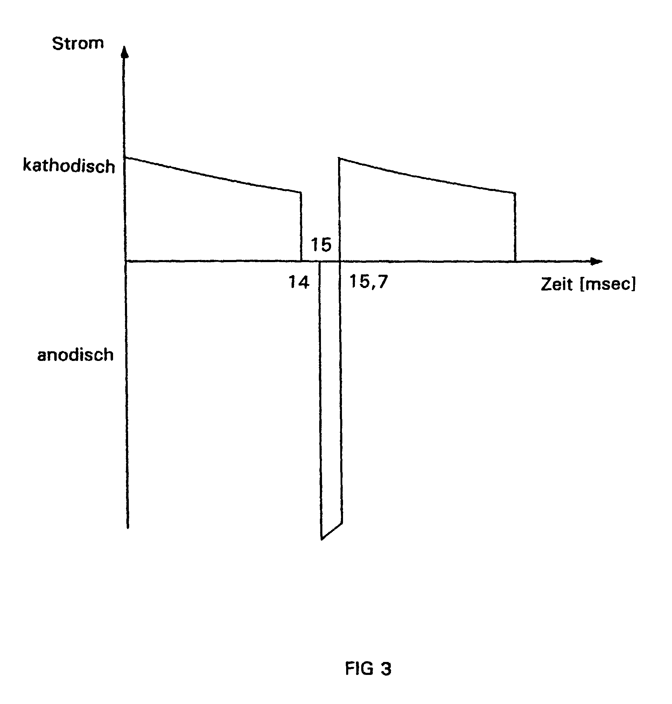

Eine bevorzugte Strom-/Spannungspulsfolge ist in Figur 3 angegeben. Mit dieser Folge wird eine weitere erhebliche Verbesserung der Metallverteilung erreicht. Die Schichtdickenverteilung insbesondere zwischen engen Vertiefungen, beispielsweise dünnen Bohrlöchern von Leiterplatten, und den übrigen Oberflächenbereichen wird dadurch deutlich verbessert. Für die einzelnen Strom-/Spannungsphasen werden die folgenden typischen Werte eingestellt:
1. Kathodischer Puls: etwa 14 msec, etwa 6 A/dm²
2. Ruhephase: etwa 1 msec, ≈ 0 A/dm²
3. Anodischer Puls: etwa 0,7 msec, etwa 15 A/dm²

Mit den verwendbaren Geräten zur Erzeugung der beschriebenen Pulsfolgen können auch mehrere kathodische und/oder anodische Strompulse mit unterschiedlichen Stromhöhen eingestellt werden.

In einer besonderen Ausführungsform wird zwischen zwei kathodischen Strompulsen an den Werkstücken alternierend entweder ein anodischer Strompuls oder eine Ruhepause mit der Stromstärke Null eingestellt.

Als Anoden werden keine löslichen Anoden aus dem abzuscheidenden Metall eingesetzt, sondern dimensionsstabile, unlösliche Anoden. Durch Verwendung der dimensionsstabilen, unlöslichen Anoden kann zeitlich ein konstanter Abstand zwischen den Anoden und den Werkstücken eingestellt werden. Die Anoden sind in ihrer geometrischen Form dem Galvanisiergut problemlos anpaßbar und verändern im Gegensatz zu löslichen Anoden ihre geometrischen Abmessungen praktisch nicht. Dadurch bleibt der die Schichtdickenverteilung an der Oberfläche des Galvanisiergutes beeinflussende Abstand zwischen Anode und Kathode konstant.

Zur Herstellung unlöslicher Anoden werden gegenüber dem Elektrolyten und bei der elektrolytischen Abscheidung inerte Materialien eingesetzt, wie beispielsweise Edelstahl oder Blei. Vorzugsweise werden aber Anoden eingesetzt, die als Grundwerkstoff Titan oder Tantal enthalten, das vorzugsweise mit Edelmetallen oder Oxiden der Edelmetalle beschichtet ist. Als Beschichtung wird beispielsweise Platin, Iridium oder Ruthenium sowie die Oxide oder Mischoxide dieser Metalle verwendet. Für die Beschichtung können neben Platin, Iridium und Ruthenium grundsätzlich auch Rhodium, Palladium, Osmium, Silber und Gold bzw. deren Oxide und Mischoxide eingesetzt werden. Eine besonders hohe Widerstandsfähigkeit gegenüber den Elektrolysebedingungen konnte beispielsweise an einer Titananode mit einer Iridiumoxidoberfläche, die mit feinen Partikeln, beispielsweise kugelförmigen Körpern, bestrahlt und dadurch porenfrei verdichtet wurde, beobachtet werden.

Durch die anodische Stromdichte wird die Menge der an der Anode entstehenden aggressiven Reaktionsprodukte beeinflußt. Es wurde festgestellt, daß deren Bildungsrate unterhalb einer anodischen Stromdichte von 2 A/dm² sehr klein ist. Daher muß die elektrochemisch wirksame Anodenoberfläche möglichst groß gewählt werden. Um möglichst große wirksame Anodenoberflächen bei trotzdem kleiner räumlicher Begrenzung zu erreichen, werden perforierte Anoden, Anodennetze oder Streckmetall mit einer entsprechenden Beschichtung verwendet. Dadurch wird zusätzlich gewährleistet, daß die Anodenoberflächen durch intensives Durchströmen der durchbrochenen Anodenmaterialien stark angeströmt werden können. Zum einen wird hierdurch die Diffusionsschichtdicke an der Anode verringert, so daß nur eine geringe Überspannung an der Anode entsteht, und zum anderen werden entstehende Reaktionsprodukte schnell von der Anodenoberfläche abgeführt. Netze und Streckmetall lassen sich zusätzlich in mehreren Lagen verwenden, so daß die Anodenfläche noch weiter erhöht und die anodische Stromdichte dadurch noch weiter verringert werden kann. Die Anodenoberflächen sollten ferner frei von Poren sein, die bis auf das Grundmaterial hinab reichen.

Da die bei der Abscheidung aus der Abscheidelösung verbrauchten Metallionen durch die Anoden nicht unmittelbar durch Auflösung nachgeliefert werden können, werden diese durch chemische Auflösung von entsprechenden Metallteilen ergänzt. Hierzu werden der Abscheidelösung Verbindungen eines elektrochemisch reversiblen Redoxsystems zugegeben, deren oxidierte Form die Metallionen in einer Redoxreaktion aus den Metallteilen bildet.

Zur Ergänzung der durch Abscheidung verbrauchten Metallionen wird daher ein Metallionen-Generator eingesetzt, in dem Teile aus dem abzuscheidenden Metall enthalten sind. Zur Regenerierung der durch Verbrauch an Metallionen verarmten Abscheidelösung wird diese an den Anoden vorbeigeführt, wobei sich die oxidierenden Verbindungen des Redoxsystems aus der reduzierten Form bilden. Anschließend wird die Lösung durch den Metallionen-Generator hindurch geleitet, wobei die oxidierenden Verbindungen mit den Metallteilen unter Bildung von Metallionen reagieren. Gleichzeitig werden die oxidierenden Verbindungen des Redoxsystems in die reduzierte Form überführt. Durch die Bildung der Metallionen wird die Gesamtkonzentration der in der Abscheidelösung enthaltenen Metallionen-Konzentration konstant gehalten. Vom Metallionen-Generator aus gelangt die Abscheidelösung wieder zurück in den mit den Kathoden und Anoden in Kontakt stehenden Elektrolytraum.

Als elektrochemisch reversibles Redoxsystem werden Eisen-(II)- und Eisen-(III)-Verbindungen verwendet. Ebenfalls geeignet sind die Redoxsysteme folgender Elemente: Titan, Cer, Vanadin, Mangan und Chrom. Sie können der Kupfer-Abscheidelösung beispielsweise in Form von Titanyl-Schwefelsäure, Cer-(IV)-sulfat, Natriummetavanadat, Mangan-(II)-sulfat oder Natriumchromat zugesetzt werden. Kombinierte Systeme können für spezielle Anwendungen vorteilhaft sein.

Aus dem der Abscheidelösung zugegebenen Eisen-(II)-sulfat-Heptahydrat bildet sich nach kurzer Zeit das wirksame Fe²⁺/Fe³⁺-Redoxsystem. Es ist hervorragend geeignet für wäßrige, saure Kupferbäder. Es können auch andere wasserlösliche Eisensalze, insbesondere Eisen-(III)-sulfat-Nonahydrat, verwendet werden, sofern sie keine biologisch nicht abbaubaren (harten) Komplexbildner enthalten, die bei der Spülwasserentsorgung Probleme bereiten können (beispielsweise Eisenammoniumalaun). Die Verwendung von Eisenverbindungen mit Anionen, die in der Kupferabscheidelösung zu unerwünschten Nebenreaktionen führen, wie beispielsweise Chlorid oder Nitrat, dürfen ebenfalls nicht eingesetzt werden.

Die Konzentrationen der Verbindungen des Redoxsystems müssen so eingestellt werden, daß durch die Auflösung der Metallteile eine konstante Konzentration der Metallionen in der Abscheidelösung aufrechterhalten werden kann. Vorzugsweise wird eine Konzentration von mindestens 10 g Eisenionen/Liter Abscheidelösung eingestellt. Damit wird gewährleistet, daß die mit Edelmetallen oder Oxiden der Edelmetalle beschichteten unlöslichen Anoden nicht beschädigt werden. Ferner wird auch das Problem beseitigt, daß die von den inerten Trägermaterialien der Anode abplatzenden Edelmetalle oder deren Oxide sich nicht auf Kupferstücken ablagern, die sich in einem gegebenenfalls verwendeten separaten Behälter befinden und die unter der Einwirkung der Eisen-(III)-ionen aufgelöst werden, um die Kupferionenkonzentration in der Abscheidelösung konstant zu halten. Außerdem wird hierdurch auch die Bildung von grobkristallinen Metallschichten im hohen Stromdichtebereich (Anbrennungen) vermieden.

Die Grundzusammensetzung eines Kupferbades kann bei Anwendung des erfindungsgemäßen Verfahrens in relativ weiten Grenzen schwanken. Im allgemeinen wird eine wäßrige Lösung der folgenden Zusammensetzung benutzt (alle Werte in g/Liter Abscheidelösung):

| | |
|---|---|
| Kupfersulfat (CuSO₄·5 H₂O) | 20 - 250 |
| vorzugsweise | 80 - 140 oder |
| | 180 - 220 |
| Schwefelsäure, konz. | 50 - 350 |
| vorzugsweise | 180 - 280 oder |
| | 50 - 90 |
| Eisen-(II)-sulfat (FeSO₄·7 H₂O) | 1 - 120 |
| vorzugsweise | 20 - 80 |
| Chloridionen (zugegeben | |
| beispielsweise als NaCI) | 0,01 - 0,18 |
| vorzugsweise | 0,03 - 0,10. |

Anstelle von Kupfersulfat können zumindest teilweise auch andere Kupfersalze benutzt werden. Auch die Schwefelsäure kann teilweise oder ganz durch Fluoroborsäure, Methansulfonsäure oder andere Säuren ersetzt werden. Die Chloridionen werden als Alkalichlorid, beispielsweise Natriumchlorid, oder in Form von Salzsäure, p.a. zugegeben. Die Zugabe von Natriumchlorid kann ganz oder teilweise entfallen, wenn in den Zusätzen bereits Halogenidionen enthalten sind.

Neben Kupfer können grundsätzlich auch andere Metalle, wie beispielsweise Nickel oder dessen Legierungen, auf die erfindungsgemäße Weise niedergeschlagen werden.

Außerdem können der Abscheidelösung beispielsweise übliche Glanzbildner, Einebner, Netzmittel und andere Zusatzstoffe zugegeben werden. Um glänzende Kupferniederschläge mit vorgegebenen physikalisch-mechanischen Eigenschaften zu erhalten, werden zumindest eine wasserlösliche Schwefelverbindung und eine sauerstoffhaltige, hochmolekulare Verbindung zugesetzt. Additivverbindungen, wie stickstoffhaltige Schwefelverbindungen, polymere Stickstoffverbindungen und/oder polymere Phenazoniumverbindungen sind ebenfalls einsetzbar.

Die Additivverbindungen sind innerhalb folgender Konzentrationsbereiche in der Abscheidelösung enthalten (alle Werte wiederum in g/Liter Abscheidelösung):

| | |
|---|---|
| übliche sauerstoffhaltige, | |
| hochmolekulare Verbindungen | 0,005 - 20 |
| vorzugsweise übliche wasserlösliche | 0,01 - 5 |
| organische Schwefelverbindungen | 0,0005 - 0,4 |
| vorzugsweise | 0,001 - 0,15 |

In Tabelle 1 sind einige sauerstoffhaltige, hochmolekulare Verbindungen aufgeführt.

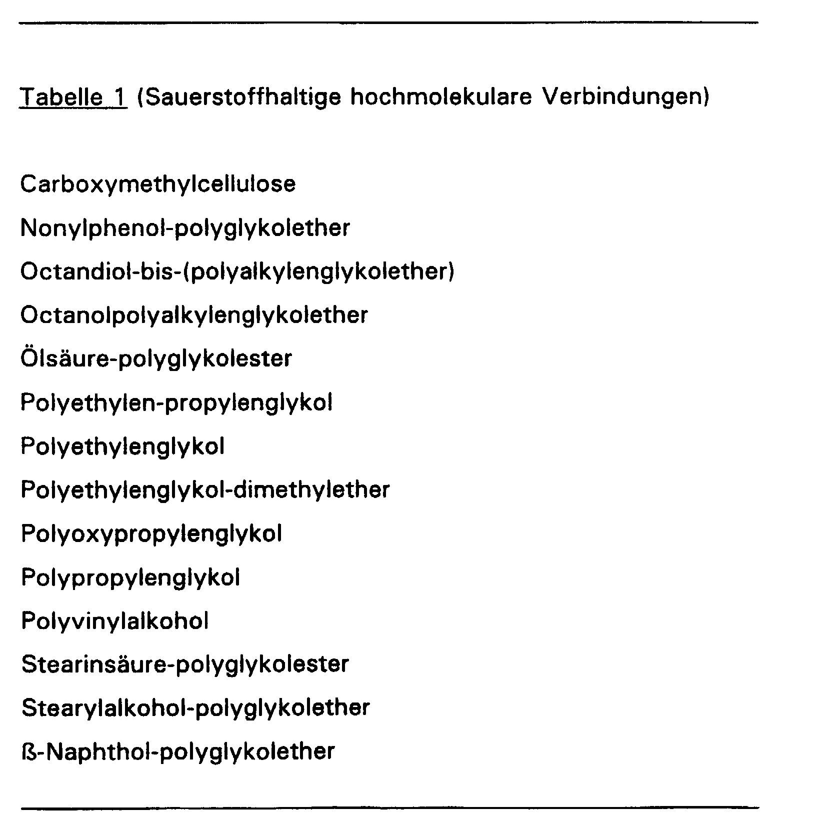

In Tabelle 2 sind verschiedene Schwefelverbindungen mit geeigneten funktionellen Gruppen zur Erzeugung der Wasserlöslichkeit angegeben.

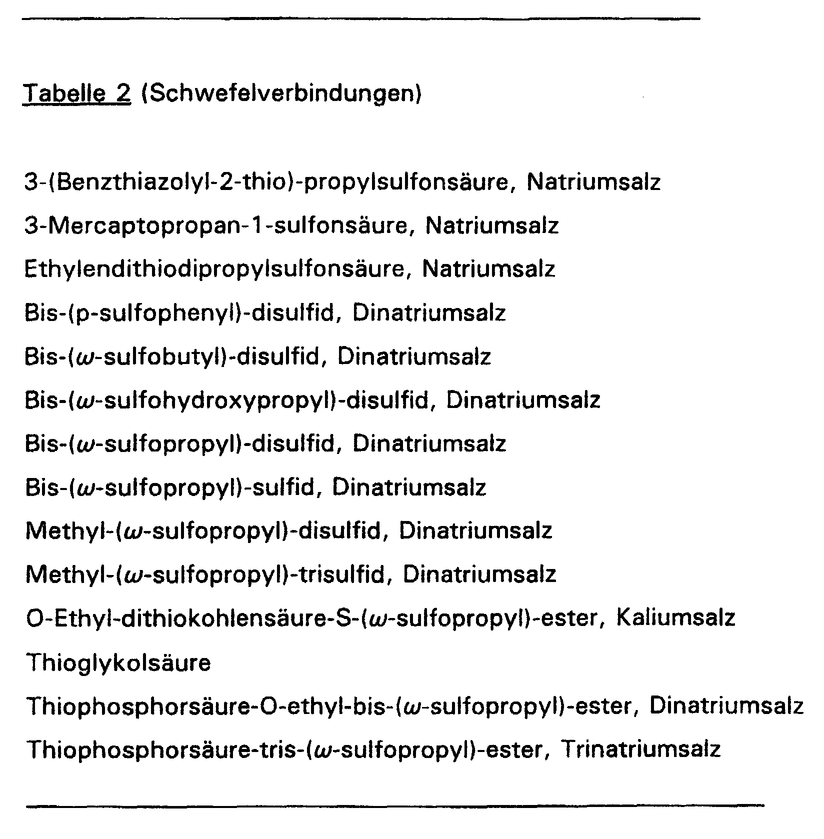

Thioharnstoffderivate und/oder polymere Phenazoniumverbindungen und/oder polymere Stickstoffverbindungen als Additivverbindungen werden in folgenden Konzentrationen eingesetzt (alle Werte wiederum in g/Liter Abscheidelösung):

| | |
|---|---|
| | 0,0001 - 0,50 |
| vorzugsweise | 0,0005 - 0,04 |

Zum Ansatz der Abscheidelösung werden die Additivverbindungen zur vorstehend angegebenen Grundzusammensetzung hinzugefügt. Nachfolgend sind die Bedingungen bei der Kupferabscheidung angegeben:

| | |
|---|---|
| pH-Wert: | < 1 |
| Temperatur: | 15 °C - 50 °C, |
| vorzugsweise | 25 °C - 40 °C |
| kathodische Stromdichte: | 0,5 - 12 A/dm² |
| vorzugsweise | 3 - 7 A/dm² |

Durch Einblasen von Luft in den Elektrolytraum wird die Abscheidelösung bewegt. Durch zusätzliches Anströmen der Anode und/oder der Kathode mit Luft wird die Konvektion im Bereich der jeweiligen Oberflächen erhöht. Dadurch wird der Stofftransport in der Nähe der Kathode bzw. Anode optimiert, so daß größere Stromdichten erreichbar sind. Gegebenenfalls in geringer Menge entstehende aggressive Oxidationsmittel, wie beispielsweise Sauerstoff und Chlor, werden dadurch von den Anoden abgeführt. Auch eine Bewegung der Anoden und Kathoden bewirkt einen verbesserten Stofftransport an den jeweiligen Oberflächen. Dadurch wird eine konstante diffusionskontrollierte Abscheidung erzielt. Die Bewegungen können horizontal, vertikal, in gleichmäßig lateraler Bewegung und/oder durch Vibration erfolgen. Eine Kombination mit der Luftanströmung ist besonders wirksam.

In einer für die Durchführung des erfindungsgemäßen Verfahrens geeigneten Anordnung mit einer Metallabscheidelösung ist
a. mindestens ein erster Behälter zur Aufnahme einer Metallabscheidelösung vorgesehen,
b. ferner mit Metall elektrolytisch zu beschichtende metallische Werkstücke, die mit der Abscheidelösung in Kontakt gebracht werden,
c. außerdem Elektroden, die den Werkstücken beabstandet gegenüber angeordnet sind und die mit der Abscheidelösung in Kontakt gebracht werden können, als Anoden aus einem sich bei der Metallabscheidung durch anodische Reaktion nicht auflösenden Material,
d. außerdem eine mit den Elektroden und den Werkstücken elektrisch verbindbare Spannungs- oder Stromversorgungseinheit, die so ausgebildet ist, daß die Elektroden und die Werkstücke mit einer Wechselspannung oder einem Wechselstrom versehen werden können,
e. außerdem mindestens ein zweiter Behälter (Kupferionen-Generator) zur Aufnahme von Stücken aus dem Metall, das auf den
Werkstücken abgeschieden wird, wobei der zweite Behälter mit dem ersten Behälter zum Flüssigkeitstransport so verbunden ist, daß die Abscheidelösung von dem ersten Behälter in den zweiten und von dort wieder zu dem ersten gefördert werden kann und
f. schließlich Einrichtungen zum Fördern der Abscheidelösung, beispielsweise Pumpen, vom ersten Behälter zum zweiten und von dort zurück zum ersten.

Die Metallabscheidelösung ist dabei im ersten Behälter enthalten und enthält Ionen des auf den Werkstücken abzuscheidenden Metalls und Verbindungen eines elektrochemisch reversiblen Redoxsystems.

In der ersten Ausführungsform (Tauchverfahren) sind die Werkstücke entweder im ersten Behälter angeordnet. In einer zweiten Ausführungsform können die Werkstücke und die Anoden auch außerhalb des Behälters angeordnet sein. In diesem Fall sind Einrichtungen zur Förderung der Abscheidelösung vom ersten Behälter zu den Werkstücken vorzusehen, beispielsweise Pumpen, um die Werkstücke und die Anoden fortwährend mit der Abscheidelösung in Kontakt zu bringen. Diese Anordnung wird in einer horizontalen Durchlaufanlage, wie sie für die Behandlung von Leiterplatten verwendet werden kann, eingesetzt.

Üblicherweise werden Beschichtungsanlagen eingesetzt, bei denen die Leiterplatten in vertikaler Lage in einen Behälter, der die Abscheidelösung enthält, eingesenkt werden und in dieser Lage den beidseitig angeordneten dimensionsstabilen, unlöslichen Anoden gegenüberliegen. Die Anoden können durch Diaphragmen vom Katholytraum, in dem sich die Leiterplatten befinden, getrennt sein. Als Diaphragmen geeignet sind beispielsweise Polypropylengewebe oder Membranen mit einer Metallionen-und Anionen-Durchlässigkeit, wie beispielsweise Nafion-Membranen (der Firma DuPont de Nemours Inc., Wilmington, Del., USA). In dieser Anordnung wird die Abscheidelösung zunächst zu den als Kathode polarisierten Leiterplatten gepumpt und von dort zu den Anoden geleitet. Die Kathoden- und Anodenoberflächen werden durch Düsenstöcke gezielt angeströmt. Diese Anlage umfaßt neben der elektrolytischen Zelle mit dem Behälter den Kupferionen-Generator, in den die von den Anoden kommende Abscheidelösung gelangt. Dort wird die Abscheidelösung wieder mit den Kupferionen angereichert.

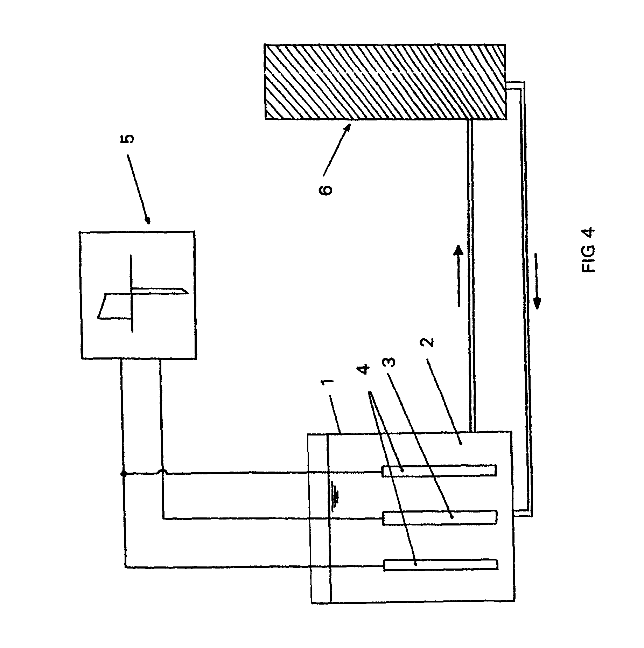

Eine typische Anordnung, die zum Behandeln der Werkstücke im Tauchverfahren geeignet ist, ist in Figur 4 schematisch dargestellt. Im Behälter 1 befindet sich die Abscheidelösung 2, die Verbindungen des elektrochemisch reversiblen Redoxsystems enthält, beispielsweise Eisen(II)- und Eisen-(III)-ionen. Die Abscheidelösung kann beispielsweise zur Verkupferung dienen und enthält dann die zuvor angegebenen Bestandteile.

In die Abscheidelösung tauchen die Werkstücke 3, beispielsweise Leiterplatten, und die Anoden 4, beispielsweise mit Iridiumoxid beschichtete Titananoden, ein. Die Werkstücke und die Anoden sind mit der Stromquelle 5 verbunden. Anstelle einer Regelung des Stromes mit der Stromquelle kann auch eine Spannungsversorgung vorgesehen sein, mit der die Spannung zwischen den Werkstücken und den Anoden geregelt wird. Die Abscheidelösung wird fortwährend mittels nicht dargestellter Fördereinrichtungen, beispielsweise Pumpen, zu einem zweiten Behälter 6 geführt.

In diesem separaten Behältnis, dem Metallionen-Generator, der von der Abscheidelösung durchflossen wird, wird das Metall in der Abscheidelösung wieder ergänzt. Im Metallionen-Generator befinden sich im Falle der Kupferabscheidung metallische Kupferteile, beispielsweise in Form von Stücken, Kugeln oder Pellets. Die Kupferteile lösen sich unter der Wirkung der oxidierten Form der Redoxverbindungen zu Kupferionen auf. Durch die Auflösung der Kupferteile wird die oxidierte Form des Redoxsystems in die reduzierte Form überführt. Die mit Kupferionen und der reduzierten Form angereicherte Lösung wird mittels der nicht dargestellten Pumpen zum ersten Behälter wieder zurückgeführt. Das für die Regenerierung verwendete metallische Kupfer braucht Phosphor nicht zu enthalten, jedoch stört Phosphor auch nicht. Beim herkömmlichen Einsatz von löslichen Kupferanoden ist die Zusammensetzung des Anodenmaterials hingegen von großer Bedeutung: In diesem Fall müssen die Kupferanoden etwa 0,05 Gew.-% Phosphor enthalten. Derartige Werkstoffe sind teuer, und der Phosphorzusatz verursacht Rückstände in der elektrolytischen Zelle, die durch zusätzliche Filterung zu entfernen sind.

In die Kreislaufführung der Abscheidelösung können ferner Filter zum Abtrennen mechanischer und/oder chemischer Rückstände eingefügt werden. Jedoch ist deren Bedarf im Vergleich zu elektrolytischen Zellen mit löslichen Anoden geringer, weil der durch die Phosphorbeimengung zu den Anoden entstehende Anodenschlamm nicht entsteht.

In der anderen bevorzugten Ausführungsform werden die Leiterplatten in horizontaler Lage und horizontaler Bewegungsrichtung durch eine Durchlaufanlage hindurchtransportiert. Dabei wird Abscheidelösung kontinuierlich von unten und/oder von oben durch Schwalldüsen oder Flutrohre an die Leiterplatten angeströmt. Die Anoden sind den Leiterplatten beabstandet gegenüber angeordnet und werden ebenso wie die Leiterplatten mittels geeigneter Einrichtung mit der Abscheidelösung in Kontakt gebracht. Die Leiterplatten werden seitlich elektrisch kontaktiert und bewegen sich auf einer Ebene, die zwischen den Anodenebenen angeordnet ist, durch die Anlage hindurch. Gegebenenfalls kann die Abscheidelösung nach Hindurchtreten durch Bohrlöcher in der Leiterplatte mittels auf der den Düsen gegenüberliegenden Seite der Leiterplatte angeordnete Einrichtungen wieder abgesaugt werden. Die Leiterplatten werden meist über Klammern elektrisch kontaktiert. Die Transportgeschwindigkeit in der Anlage beträgt 0,01 bis 2,5 cm/sec, vorzugsweise 0,2 - 1,7 cm/sec. Die Leiterplatten werden mittels Rollen oder Scheiben transportiert.

Mit dem erfindungsgemäßen Verfahren können vor allem Leiterplatten mit Kupferschichten auf den Oberflächen und auf den bereits dünn mit Kupfer metallisierten Mantelflächen der Bohrungen elektrolytisch beschichtet werden.

Die folgenden Beispiele dienen zur weiteren Erläuterung der Erfindung:

### Beispiel 1 (Vergleichsbeispiel):

In einer Elektrolysezelle, die mit löslichen, phosphorhaltigen Kupferanoden versehen ist, wurde ein wäßriges Kupferbad mit der folgenden Zusammensetzung eingesetzt:

| | |
|---|---|
| Kupfersulfat (CuSO₄·5 H₂O) | 80 g/Liter, |
| Schwefelsäure, konz. | 180 g/Liter, |
| Eisen-(II)-sulfat (FeSO₄·7 H₂O) | 35 g/Liter, |
| Natriumchlorid | 0,08 g/Liter |

und folgenden glanzbildenden Additivverbindungen:

| | |
|---|---|
| Polypropylenglykol | 1,5 g/Liter, |
| 3-Mercaptopropan-1-sulfonsäure, Natriumsalz | 0,006 g/Liter, |
| N-Acetylthioharnstoff | 0,001 g/Liter. |

Bei einer Elektrolyttemperatur von 30 °C wurde Kupfer mit einer Stromdichte von 4 A/dm² auf eine an den Oberflächen mit Kupferlaminat und in den Bohrungen mit einer dünnen Kupferschicht versehenen Leiterplatte mit einer Dicke von 1,6 mm und Bohrungen mit einem Durchmesser von 0,4 mm abgeschieden, die zur Beurteilung der Einebnung der abgeschiedenen Kupferschicht durch Kratzen mit Riefen im Kupferlaminat versehen wurde.

Es wurde eine hochglänzende Kupferschicht erhalten. Die Metallstreuung (Schichtdicke in den Bohrlöchern x 100/Schichtdicke an der Leiterplattenoberfläche) betrug jedoch nur 55 %. Die Bruchelongation einer aus der Lösung abgeschiedenen Kupferfolie betrug 21 % (gemessen mit der Wölbungstestmethode mit dem Ductensiomat nach der DIN-ISO-Methode 8401, beschrieben in: R. Schulz, D. Nitsche, N. Kanani in: Jahrbuch der Oberflächentechnik, 1992, Seiten 46 ff.).

### Beispiel 2 (Vergleichsbeispiel):

Mit der in Beispiel 1 verwendeten Elektrolytlösung wurde eine Kupferschicht mittels eines Pulsstromverfahrens abgeschieden. Die Pulsstromfolge gemäß Figur 1 enthielt folgende Strompulse:

| | | |
|---|---|---|
| Strom, kathodisch | Stromdichte: 4 A/dm² | Dauer: 10 msec, |
| Strom, anodisch | Stromdichte: 8 A/dm² | Dauer: 0,5 msec. |

Gegenüber dem Ergebnis aus Beispiel 1 verbesserte sich die Metallstreuung von 55 % auf 75 %. Jedoch konnten keine verwendbaren Kupferschichten erhalten werden, da deren Aussehen unakzeptabel war. Die Kupferschicht war lediglich matt. Außerdem verschlechterte sich die Bruchelongation der unter diesen Bedingungen abgeschiedenen Kupferfolie von 21 % auf 14 %.

### Beispiel 3 (Vergleichsbeispiel):

Beispiel 1 mit Gleichstrom wurde wiederholt. Anstelle der löslichen, phosphorhaltigen Kupferanoden wurde ein mit Mischoxiden beschichtetes Titanstreckmetall als dimensionsstabile, unlösliche Anode verwendet.

Die abgeschiedenen Kupferschichten waren zunächst gleichmäßig glänzend. Auch die physikalisch-mechanischen Eigenschaften waren zufriedenstellend. Jedoch wurden Metallstreuungswerte gemessen, die unterhalb den in Beispiel 1 angegebenen Werten lagen. Nach längerem Betrieb des Abscheidebades verschlechterten sich das Aussehen und die Bruchelongation der Schichten. Gleichzeitig wurde festgestellt, daß die Mischoxidbeschichtung von der Titananode abplatzte. Dies führte dazu, daß die Überspannung an der Anode stark anstieg.

### Beispiel 4:

Mit der in Beispiel 1 angegebenen Elektrolytlösung wurde wiederum eine mit Kupferlaminat versehene Leiterplatte elektrolytisch verkupfert. Jedoch wurden nicht lösliche Kupferanoden verwendet, sondern eine dimensionsstabile, unlösliche Anode. Als Anode diente ein mit Mischoxiden beschichtetes Titanstreckmetall. Außerdem wurde in der Abscheidelösung eine Konzentration von Eisen-(II)-sulfat (FeSO₄ · 7 H₂O) von 75 g/Liter eingestellt. Zur Regenerierung der Kupferionen wurde die Abscheidelösung vom Behandlungsbehälter in einen separaten Behälter gepumpt, der mit Kupferstücken gefüllt war. Durch Oxidation des Kupfers mit den als Oxidationsmittel wirkenden Eisen-(III)-ionen, die durch Oxidation der Eisen-(II)-ionen an den Anoden kontinuierlich gebildet wurden, wurden die Kupferstücke sukzessive aufgelöst, und es bildeten sich Kupferionen. Die mit den Kupferionen angereicherte Abscheidelösung gelangte von diesem Behälter wieder in den Behandlungsbehälter.

Unter Anwendung der in Beispiel 2 angegebenen Pulsstromfolge konnte eine gleichmäßig hochglänzende Kupferschicht auf der Leiterplatte erhalten werden. Die Metallstreuung verschlechterte sich gegenüber diesem Beispiel nicht und wies demnach deutlich bessere Werte auf als gemäß Beispiel 1.

Nachdem über einen längeren Zeitraum hinweg aus der Lösung Kupfer abgeschieden worden war (geflossene Ladungsmenge pro Lösungsvolumen: 10 Ah/Liter), betrug die nach der Wölbungstestmethode bestimmte Bruchelongation einer aus dieser gealterten Lösung und unter den vorgenannten Bedingungen abgeschiedenen Kupferfolie 20 % und lag damit im Bereich des nach Beispiel 1 ermittelten Wertes. Die unlöslichen Anoden zeigten keine Anzeichen von Beschädigungen.

Die auf den Leiterplattenoberflächen und in den Bohrungen abgeschiedene Kupferschicht überstand einen Thermoschocktest, ohne daß sich Risse in der Kupferschicht, insbesondere auch nicht an den Übergängen von der Leiterplattenoberfläche zu den Bohrungen, zeigten. Hierzu wurde die Leiterplatte zweimal in ein 288 °C heißes Lotbad eingetaucht und dazwischen bei Raumtemperatur abgekühlt.

### Beispiel 5 (Vergleichsbeispiel):

In einer zur horizontalen Behandlung von Leiterplatten dienenden Durchlaufanlage wurden kupferkaschierte und in den Bohrungen mit einer dünnen Kupferschicht versehene Leiterplatten in einer Elektrolytlösung mittels Gleichstrom verkupfert. Als Anoden wurden phosphorhaltige Kupferanoden verwendet. Die Elektrolytlösung hatte folgende Zusammensetzung:

| | |
|---|---|
| Kupfersulfat (CuSO₄·5 H₂O) | 80 g/Liter, |
| Schwefelsäure, konz. | 200 g/Liter, |
| Eisen-(III)-sulfat (Fe₂(SO₄)₃·9 H₂O) | 35 g/Liter, |
| Natriumchlorid | 0,06 g/Liter |

mit folgenden glanzbildenden Additivverbindungen:

| | |
|---|---|
| Polyethylenglykol | 1,0 g/Liter, |
| 3-(Benzthiazolyl-2-thio)-propyl-sulfonsäure, Natriumsalz | 0,01 g/Liter, |
| Acetamid | 0,05 g/Liter. |

Bei einer Elektrolyttemperatur von 34 ° C wurde bei einer Stromdichte von 6 A/dm² eine glänzende Kupferschicht auf dem zuvor durch Kratzen mit Riefen versehenen Laminat erhalten. Die Leiterplatte wurde einem fünfmaligen Thermoschocktest in einem Lotbad unterworfen. Es zeigten sich keine Risse in der Kupferschicht. Die Metallstreuung in Bohrungen mit einem Durchmesser von 0,6 mm betrug 62 %.

### Beispiel 6 (Vergleichsbeispiel):

Der Versuch von Beispiel 5 wurde wiederholt. Allerdings wurde anstelle von Gleichstrom ein Pulsstromverfahren nach Figur 1 mit folgenden Parametern angewendet:

| | | |
|---|---|---|
| Strom, kathodisch | Stromdichte: 6 A/dm² | Dauer: 10 msec, |
| Strom, anodisch | Stromdichte: 10 A/dm² | Dauer: 0,5 msec. |

Gegenüber Beispiel 4 wurde eine wesentlich bessere Metallstreuung erreicht. Sie betrug 85 % in den 0,6 mm großen Bohrungen. Allerdings verschlechterte sich das Aussehen der abgeschiedenen Kupferschicht deutlich: Die Kupferschicht war nicht gleichmäßig und zeigte matte Flecken. Beim Thermoschocktest mit den vorstehend beschriebenen Bedingungen zeigten sich nach fünfmaligem Eintauchen in ein Lotbad Risse in der Kupferschicht.

### Beispiel 7:

Unter den in Beispiel 4 angegebenen Bedingungen wurden Leiterplatten unter Verwendung einer mit Platin beschichteten Titanstreckmetallanode anstelle von löslichen Kupferanoden mit Kupfer beschichtet. Anstelle von Gleichstrom wurde ein Pulsstromverfahren mit den in Beispiel 6 angegebenen Parametern angewendet. Außerdem wurde der Gehalt von Eisen-(II)-sulfat (FeSO₄ · 7H₂O) in der Abscheidelösung auf 80 g/Liter angehoben.

Die abgeschiedene Kupferschicht war gleichmäßig hochglänzend und wies damit ein wesentlich besseres Aussehen auf als die nach der Methode des Beispiels 5 hergestellte Leiterplatte. Die Leiterplatte wurde wiederum einem fünfmaligen Thermoschocktest in einem 288 C heißen Lotbad durch Eintauchen und zwischenzeitlichen Abkühlen bei Raumtemperatur unterworfen. Es konnten keine Risse in der Kupferschicht festgestellt werden. Außerdem verbesserten sich die Metallstreuungswerte gegenüber Beispiel 6. Es wurden Werte oberhalb von 85 % gemessen. Die unlöslichen Anoden waren auch über längere Zeit stabil.

## Patentansprüche

1. Verfahren zur elektrolytischen Abscheidung von Metallschichten insbesondere von Kupferschichten, mit gleichmäßiger Schichtdicke in verteilung sowie gleichmäßigem Glanz hoher Bruchelongation und Zugfestigkeit auch an Stellen hoher Stromdichten, mittels eines Pulsstrom- oder Pulsspannungsverfahrens
a-) auf komplex geformten Werkstücken als Kathoden und
b-) durch Verwendung von mit Edelmetallen oder Oxiden der Edelmetalle beschichteten inerten dimensionsstabilen unlöslichen Anoden
c-) aus einer Abscheidelösung, enthaltend
c1) Ionen des abzuscheidenden Metalls,
c2) Additivverbindungen zur Steuerung des Glanzes, der Bruchelongation und der Zugfestigkeit sowie
- Verbindungen mindestens eines elektrochemisch reversiblen Redoxsystems, durch dessen oxidierte Form die Ionen des abzuscheidenden Metalls durch Auflösung entsprechender Metallteile gebildet werden.

2. Verfahren nach Anspruch 1, dadurch gekennzeichnet, daß eine eingestellte Strompulsfolge mit anodischen und kathodischen Strompulsen an den Werkstücken und gegebenenfalls mit dazwischen liegenden Ruhepausen mit der Stromstärke Null periodisch wiederholt wird oder sich bei entsprechender Regelung der Spannung einstellt.

3. Verfahren nach einem der vorstehenden Ansprüche, dadurch gekennzeichnet, daß der Strom der anodischen Strompulse zwei- bis dreimal so hoch eingestellt wird wie der Strom der kathodischen Strompulse.

4. Verfahren nach einem der vorstehenden Ansprüche, dadurch gekennzeichnet, daß die Dauer eines anodischen Strompulses an den Werkstücken von 0,3 Millisekunden bis 10 Millisekunden eingestellt wird.

5. Verfahren nach einem der vorstehenden Ansprüche, dadurch gekennzeichnet, daß zwischen zwei kathodischen Strompulsen an den Werkstücken alternierend entweder ein anodischer Strompuls oder eine Ruhepause mit der Stromstärke Null eingestellt wird oder eine Kombination eines anodischen Strompulses und einer Ruhepause.

6. Verfahren nach einem der vorstehenden Ansprüche, dadurch gekennzeichnet, daß als Anode mit Iridiumoxid beschichtetes und mittels feiner Partikel bestrahltes Titan-Streckmetall eingesetzt wird.

7. Verfahren nach einem der vorstehenden Ansprüche, dadurch gekennzeichnet, daß als elektrochemisch reversibles Redoxsystem Eisen(II)- und Eisen-(III)-Verbindungen verwendet werden.

8. Verfahren nach Anspruch 7, dadurch gekennzeichnet, daß in der Abscheidelösung eine Eisenionen-Konzentration von mindestens 10 g/Liter eingestellt wird.

9. Verfahren nach einem der vorstehenden Ansprüche zur elektrolytischen Abscheidung von Kupferschichten auf Oberflächen und Mantelflächen von Bohrungen von Leiterplatten.

## Claims

1. Method of electrolytically depositing fine-crystalline metal layers, more especially copper layers, with a uniform layer thickness distribution and also with a uniform shine, a high breaking elongation and tensile strength, even at locations of high current density, by means of a pulse current or pulse voltage method
a) on complexly shaped workpieces as cathodes and
b) by use of inert, dimensionally stable, insoluble anodes coated with noble metals or oxides of the noble metals,
c) from a deposition solution, containing
c1) ions of the metal to be deposited,
c2) additive compounds to control the shine, the breaking elongation and the tensile strength, as well as
- compounds of at least one electrochemically reversible redox system, by means of the oxidised form of which system the ions of the metal to be deposited are formed by resolution of corresponding metal parts.

2. Method according to claim 1, characterised in that a set current pulse sequence, having anodic and cathodic current pulses on the workpieces, and possibly having inoperative pauses with the current intensity zero situated therebetween, is periodically repeated or is set with a corresponding regulation of the voltage.

3. Method according to one of the preceding claims, characterised in that the current of the anodic current pulses is set to be two- to three-times as high as the current of the cathodic current pulses.

4. Method according to one of the preceding claims, characterised in that the duration of an anodic current pulse at the workpieces is set from 0.3 milliseconds to 10 milliseconds.

5. Method according to one of the preceding claims, characterised in that either an anodic current pulse or an inoperative pause with the current intensity zero is set alternately between two cathodic current pulses on the workpieces, or a combination of an anodic current pulse and an inoperative pause is set therebetween.

6. Method according to one of the preceding claims, characterised in that expanded titanium metal, which is coated with iridium oxide and irradiated by means of fine particles, is used as the anode.

7. Method according to one of the preceding claims, characterised in that iron-(II) and iron-(III) compounds are used as the electrochemically reversible redox system.

8. Method according to claim 7, characterised in that an iron ion concentration of at least 10 g/litre is set in the deposition solution.

9. Method according to one of the preceding claims for electrolytically depositing copper layers on top surfaces and inner surfaces of bores of printed circuit boards.

## Revendications

1. Procédé de dépôt électrolytique de couches métalliques, notamment des couches de cuivre, ayant une épaisseur de couche uniforme dans sa répartition ainsi qu'un brillant uniforme et une résistance à la traction et une élongation à la rupture élevées, y compris dans les zones avec des densités de courant élevées, au moyen d'un procédé par courant pulsé ou tension pulsée
a) sur des pièces à traiter de forme complexe servant de cathode, et
b) en utilisant des anodes inertes insolubles stables dimensionnellement, revêtues de métaux nobles ou d'oxydes de métaux nobles,
c) à partir d'une solution de dépôt contenant :
c1) des ions du métal à déposer,
c2) des composés additifs pour contrôler le brillant, l'élongation à la rupture et la résistance à la traction, ainsi que
- des composés d'au moins un système oxydoréducteur réversible électrochimiquement, par la forme oxydée duquel les ions du métal à déposer sont formés par dissolution des constituants métalliques correspondants.

2. Procédé selon la revendication 1, caractérisé en ce qu'un train d'impulsions de courant réglé avec des impulsions de courant anodique et cathodique au niveau de la pièce à traiter, avec le cas échéant entre celles-ci des pauses intermédiaires à une intensité de courant nulle, se répète périodiquement ou s'établit pour un réglage correspondant de la tension.

3. Procédé selon l'une des revendications précédentes, caractérisé en ce que l'intensité des impulsions de courant anodique est réglée à une valeur deux à trois fois supérieure à l'intensité des impulsions de courant cathodique.

4. Procédé selon l'une des revendications précédentes, caractérisé en ce que la durée d'une impulsion de courant anodique au niveau des pièces à traiter est réglée de 0,3 millisecondes à 10 millisecondes.

5. Procédé selon l'une des revendications précédentes, caractérisé en ce que, entre deux impulsions de courant cathodique au niveau des pièces à traiter, on règle de manière alternée soit une impulsion de courant anodique, soit une pause avec une intensité de courant nulle, soit une combinaison d'une impulsion de courant anodique et une pause.

6. Procédé selon l'une des revendications précédentes, caractérisé en ce que l'on utilise comme anode un métal déployé en titane revêtu d'oxyde d'iridium et bombardé au moyen de fines particules.

7. Procédé selon l'une des revendications précédentes, caractérisé en ce que l'on utilise comme système oxydoréducteur réversible électrochimiquement des composés ferreux et ferriques.

8. Procédé selon la revendication 7, caractérisé en ce que, on ajuste une concentration en ions de fer dans la solution de dépôt d'au moins 10 g/litre.

9. Procédé selon l'une des revendications précédentes pour le dépôt électrolytique de couches de cuivre sur des surfaces et des parois de trous de circuits imprimés.
